# EUROPÄISCHE PATENTANMELDUNG

(11) **EP 1 014 454 A2**
(43) Veröffentlichungstag der Anmeldung: **28.06.2000**
(21) Anmeldenummer: 99125393.1
(22) Anmeldetag: 20.12.1999
(51) Int. Cl.: H01L 31/04, H01L 31/052

(54) **Thermophotovoltaischer Generator**

(30) Priorität: 21.12.1998 DE 19859076
(71) Anmelder: ROBERT BOSCH GMBH, 70442 Stuttgart (DE)
(72) Erfinder: Laqua, Ekkehard, 68794 Oberhausen (DE); Schmid, Jürgen, 34128 Kassel (DE)

(57) **Zusammenfassung**

Die Erfindung betrifft einen thermophotovoltaischen Generator (1) mit mindestens einer Strahlungsquelle (3a bis 3e) und einer oder mehreren Photozellen (7a bis 7d), wobei die Photozelle (7a bis 7d) eine von der Strahlungsquelle (3a bis 3e) emittierte Strahlung zumindest teilweise absorbiert und die absorbierte Strahlung zur Stromerzeugung nutzt. Erfindungsgemäß ist vorgesehen, daß mindestens zwei Strahlungsquellen (3a bis 3e) vorgesehen sind, daß die Photozelle eine transparente Photozelle (7a bis 7d) ist, so daß ein nicht absorbierter Strahlungsanteil die Photozelle (7a bis 7d) passiert, wobei die Photozelle (7a bis 7d) so zwischen den beiden Strahlungsquellen (3a bis 3e) angeordnet ist, daß die von der einen Strahlungsquelle (3a) emittierte, die Photozelle (7a) passierende Strahlung auf eine andere Strahlungsquelle (3b) trifft.

## Beschreibung

### Stand der Technik

Die Erfindung betrifft einen thermophotovoltaischen Generator mit mindestens einer Strahlungsquelle und einer oder mehreren Photozellen, wobei die Photozelle eine von der Strahlungsquelle emittierte Strahlung zumindest teilweise absorbiert und die absorbierte Strahlung zur Stromerzeugung nutzt. Die Photozelle ist also im Strahlengang der von einer Strahlungsquelle emittierten Strahlung angeordnet.

Thermophotovoltaische Generatoren zur Stromerzeugung sind bekannt. In den bekannten Generatoren sind die zur Stromerzeugung nötigen Photozellen stets gegenüber einem Strahler angeordnet. Die bekannten Generatoren sind mit Photozellen bestückt, deren Rückseite beschichtet ist. Im allgemeinen wird nicht jede von einer Strahlungsquelle emittierte Strahlung von den Photozellen absorbiert. Ferner kann es vorkommen, daß eine Photozelle den Strahlungsanteil, den sie absorbieren kann, nicht hundertprozentig absorbiert. Derjenige Strahlunganteil, die nicht im Halbleitermaterial der Photozellen absorbiert wird oder absorbiert werden kann, wird statt dessen von der Beschichtung der Rückseite der Photozellen absorbiert. Diese Absorption führt lediglich zur Erwärmung der Photozellen und dient nicht der Stromerzeugung. Damit geht nicht nur Strahlungsenergie zur Stromerzeugung verloren. Die Erwärmung der Photozellen hat auch zur Folge, daß diese stärker gekühlt werden müssen. Um dies zu vermeiden, werden im allgemeinen teure selektive Strahlungsquellen eingesetzt, die nur Strahlung einer bestimmten Wellenlänge oder in einem bestimmten Wellenlängenbereich emittieren. Diese Strahlungsquellen müssen auf die verwendeten Photozellen und ihre Absorptionsfähigkeit abgestimmt sein. Dies ist aufwendig und teuer.

### Vorteile der Erfindung

Der Vorteil der vorliegenden Erfindung, bei der mindestens zwei Strahlungsquellen vorgesehen sind und die Photozelle eine transparente Photozelle ist, so daß ein nicht absorbierter Strahlungsanteil die Photozelle passiert, wobei die Photozelle so zwischen den beiden Strahlungsquellen angeordnet ist, daß die von einer der Strahlungsquellen emittierte, die Photozelle passierende Strahlung auf eine andere Strahlungsquelle trifft, hat den Vorteil, daß Strahlung, die im Halbleitermaterial der ersten Photozelle nicht absorbiert wird, nicht verloren geht, sondern eine zweite Strahlungsquelle trifft. Der nicht absorbierte Strahlungsanteil tritt also durch die Photozelle hindurch und wird von einer weiteren Strahlungsquelle absorbiert. Diese Strahlungsquelle wird damit erwärmt. Normalerweise wird die Strahlungsquelle durch Erwärmung zur Emission von Strahlung angeregt. Zu diesem Zweck wird ihr von außen Energie zugeführt, z. Bsp. in Form von Brennstoff. Die zusätzliche Erwärmung durch den von den Photozellen nicht absorbierten Strahlungsanteil tritt nun zusätzlich neben die Erwärmung der Strahlungsquelle durch Zufuhr von Energie. Diese in Form von Strahlungsenergie absorbierte Energie muß somit dem erfindungsgemäßen Generator nicht von außen zugeführt werden. Dadurch wird der Systemwirkungsgrad erhöht. Außerdem wird die Kühlung der Photozellen weniger aufwendig, da diese sich weniger stark erwärmen. Die vorliegende Erfindung erlaubt die Verwendung nichtselektiver Strahlungsquellen, die Strahlung über ein breites Spektrum emittieren. Diese Strahlung geht in dem erfindungsgemäßen Generator kaum verloren, obwohl sie nur teilweise von den Photozellen absorbiert werden kann, sondern wird in sinnvoller Weise genutzt.

Durch die in den Unteransprüchen genannten Maßnahmen sind vorteilhafte Weiterbildungen und Verbesserungen der in Anspruch 1 genannten Vorrichtung möglich. Als Strahlungsquellen sind insbesondere Brennstoffstrahler geeignet, wobei auf eine thermische Abschirmung der Photozellen zu achten ist, z. Bsp. durch die Kühlung der Photozellen, die Geometrie der Anordnung von Photozellen und Brennstoffstrahlern bzw. die Evakuierung der ganzen Anordnung. Zur Verstärkung des Effekts der Erwärmung der Strahlungsquellen kann der Generator noch mit einer reflektierenden Isolationsschicht versehen sein.

### Zeichnung

Im folgenden wird ein Ausführungsbeispiel anhand der beiliegenden Zeichnung näher beschrieben. Die einzige Figur zeigt eine schematische Darstellung eines Querschnitts durch eine Ausführungsform eines erfindungsgemäßen thermophotovoltaischen Generators.

### Beschreibung des Ausführungsbeispiels

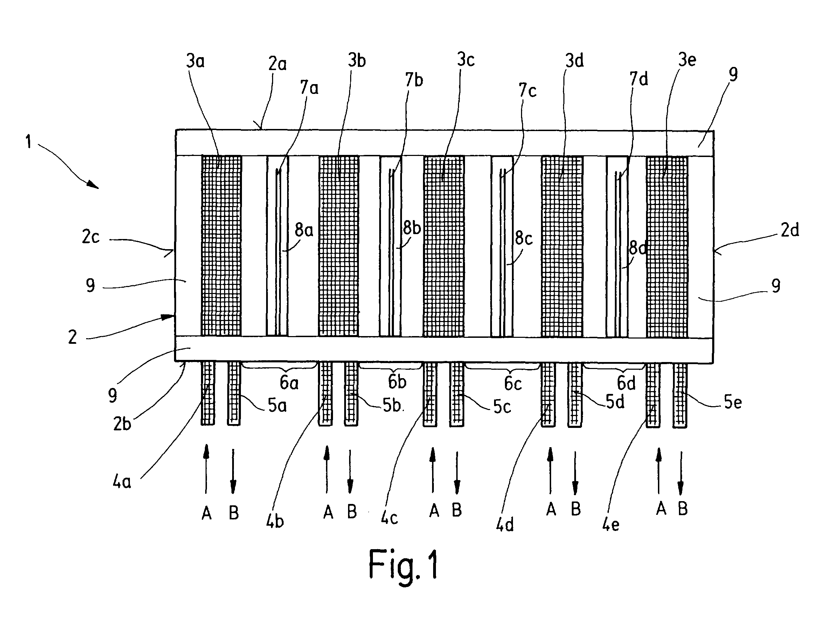

Figur 1 zeigt schematisch einen Querschnitt durch ein Ausführungsbeispiel eines erfindungsgemäßen Generators 1. Der Generator 1 weist ein Gehäuse 2 auf, von dem eine obere Wand 2a, eine untere Wand 2b sowie zwei Seitenwände 2c und 2d dargestellt sind. Im Gehäuse 2 sind mehrere Strahlungsquellen 3a, 3b, 3c, 3d und 3e, aufgenommen, die nichtselektiv strahlen, also über einen bestimmten Wellenlängenbereich unspezifisch sowohl kurz- als auch langwellige Strahlung emittieren. Im Ausführungsbeispiel handelt es sich um Brennstoffstrahler. Jeder Brennstoffstrahler 3a, 3b, 3c, 3d und 3e ist mit je einer Brennstoffzufuhreinrichtung 4a bis 4e versehen, über welche Brennstoff zugeführt wird. Die Brennstoffzufuhr erfolgt in der mit dem Pfeil A angedeuteten Strömungsrichtung. Die aus der Verbrennung resultierenden Brenngase verlassen die Brennstoffstrahler 3a bis 3e und den Generator 1 über je eine Abgasabführeinrichtung 5a bis 5e in der mit dem Pfeil B symbolisierten Strömungsrichtung.

Andere Strahlertypen sind natürlich auch verwendbar. Insbesondere können viele verschiedene breitbandige und nichtselektive Strahler verwendet werden.

Die Brennstoffstrahler 3a bis 3e sind im Abstand voneinander angeordnet, so daß Zwischenräume 6a bis 6d vorhanden sind. In jedem dieser Zwischenräume 6a bis 6d ist zwischen den Brennstoffstrahlern 3a bis 3e je eine Photozelle 7a, 7b, 7c, 7d angeordnet. Die Photozellen 7a bis 7d sind mit einer Kühlung (8a bis 8d) ummantelt, um eine Überhitzung zu vermeiden. Bei dieser Kühlung (8a bis 8d) kann es sich um eine Luftkühlung handeln, wobei die erwärmte Luft dem Verbrennungsprozeß in den Brennstoffstrahlern 3a bis 3e zugeführt werden kann, um Verluste an thermischer Energie zu verringern. Es kann aber auch eine Flüssigkeitskühlung vorgesehen sein.

Zusätzlich ist das die Brennstoffstrahler 3a bis 3e und die Photozellen 7a bis 7d aufnehmende Gehäuse 2 des Generators 1 evakuiert, so daß die Photozellen 7a bis 7d nicht mit konvektiver Wärme oder mit durch Wärmeleitung zugeführter Wärme beaufschlagt werden können. Ferner sind die Abgasabführeinrichtungen 5a bis 5e, in der die heißen Brenngase aus dem Generator 1 abgeführt werden, von den Photozellen 7a bis 7d räumlich getrennt angeordnet und so geführt, daß die heißen Abgase von den Photozellen 7a bis 7d weggeleitet werden.

Es sind auch Anordnungen denkbar, die nicht evakuiert sind. Dabei sollte die Abgasabführung so ausgelegt sein, daß die Photozellen nicht mit Wärme beaufschlagt werden.

Die Photozellen 7a bis 7d sind transparent. Sie sind mit Halbleitermaterial versehen, welches in der Lage ist, Strahlung bestimmter Wellenlängen zu absorbieren und diese Strahlungsenergie in elektrische Energie zur Stromerzeugung umzuwandeln. Diejenige Strahlung, die nicht absorbiert werden kann, passiert die Photozellen 7a bis 7d und treffen auf einen weiteren Brennstoffstrahler 3a bis 3e. Zum Beispiel emittiert der Brennstoffstrahler 3a Strahlung, die auf die Photozelle 7a trifft. Ein Teil dieser Strahlung wird von der Photozelle 7a absorbiert. Der nicht absorbierte Teil der Strahlung tritt durch die Photozelle 7a durch und trifft auf den Brennstoffstrahler 3b, der dadurch erwärmt wird. Daher können breitbandige nichtselektive Strahler 2 verwendet werden, denn die Photozellen 6 filtern sich die benötigten Wellenlängen selbst heraus. Es ist lediglich eine reflektierende Isolation 9 vorgesehen, welche die Innenseite der Wände des Generators 1 bedeckt, so daß die Brennstoffstrahler 3a bis 3e nur in Richtung der Photozellen 7a bis 7d strahlen.

Die die Photozellen 7a bis 7d durchdringende Strahlung wird also von einem weiteren Brennstoffstrahler 3a bis 3e absorbiert. Diese absorbierte Strahlung dient der Erwärmung dieses weiteren Brennstoffstrahlers 3a bis 3e. Diese über die Strahlungswärme absorbierte Energie muß somit nicht über die Brennstoffzufuhreinrichtung 4a bis 4e nachgeführt werden. Dadurch wird der Systemwirkungsgrad erhöht. Es geht weniger thermische Energie verloren. Die auf diese Weise genutzte Strahlung kann also nicht mehr die Photozellen 7a bis 7d erwärmen, so daß der Aufwand für die Kühlung geringer ist.

Selbstverständlich sind verschiedene Geometrien des Generators und verschiedene Anordnungen der Strahlungsquellen und Photozellen denkbar und möglich, mit denen die soeben beschriebene Funktionsweise verwirklicht werden kann. Die Photozellen und Strahlungsquellen können, wie in Figur 1 dargestellt, hintereinander angeordnet sein. Es können auch mehrere Photozellen rund um eine Strahlungsquelle bzw. mehrere Strahlungsquellen rund um eine Photozelle angeordnet sein. Dabei ist lediglich darauf zu achten, daß die durch eine Photozelle tretende Strahlung auf eine Strahlungsquelle trifft.

## Patentansprüche

1. Thermophotovoltaischer Generator (1) mit mindestens einer Strahlungsquelle (3a bis 3e) und einer oder mehreren Photozellen (7a bis 7d), wobei die Photozelle (7a bis 7d) eine von der Strahlungsquelle (3a bis 3e) emittierte Strahlung zumindest teilweise absorbiert und die absorbierte Strahlung zur Stromerzeugung nutzt, dadurch gekennzeichnet, daß mindestens zwei Strahlungsquellen (3a bis 3e) vorgesehen sind, daß die Photozelle eine transparente Photozelle (7a bis 7d) ist, so daß ein nicht absorbierter Strahlungsanteil die Photozelle (7a bis 7d) passiert, wobei die Photozelle (7a bis 7d) so zwischen den beiden Strahlungsquellen angeordnet ist, daß die von der einen Strahlungsquelle (3a) emittierte, die Photozelle (7a) passierende Strahlung auf eine andere Strahlungsquelle (3b) trifft.

2. Generator nach Anspruch 1, dadurch gekennzeichnet, daß die Photozelle (7a bis 7d) mit einer Kühlung (8) versehen ist.

3. Generator nach Anspruch 2, dadurch gekennzeichnet, daß die Photozelle (7a bis 7d) mit einer Luftkühlung oder einer Wasserkühlung versehen ist.

4. Generator nach einem der vorhergehenden Ansprüche, dadurch gekennzeichnet, daß die Strahlungsquellen (3a bis 3e) breitbandige, nichtselektive Strahlungsquellen sind.

5. Generator nach einem der vorhergehenden Ansprüche, dadurch gekennzeichnet, daß die Strahlungsquellen (3a bis 3e) Brennstoffstrahler sind, welche mit einer Brennstoffzufuhreinrichtung (4a bis 4e) und einer Abgasabführeinrichtung (5a bis 5e) ausgestattet sind.

6. Generator nach Anspruch 5, dadurch gekennzeichnet, daß die Abgasabführeinrichtungen (5a bis 5e) so angeordnet sind, daß die Photozelle (7a bis 7d) nicht mit Wärme beaufschlagt wird.

7. Generator nach Anspruch 6, dadurch gekennzeichnet, daß die Abgasabführeinrichtungen (5a bis 5e) im Abstand von der Photozelle (7a bis 7d) angeordnet sind und/oder die Abgase von der Photozelle (7a bis 7d) wegleiten.

8. Generator nach einem der Ansprüche 5 bis 7, dadurch gekennzeichnet, daß die Abgasabführeinrichtung (5a bis 5e) derart in Nachbarschaft mindestens eines Brennstoffstrahlers (3a bis 3e) angeordnet ist, daß der Brennstoffstrahler (3a bis 3e) mit der von den Abgasen mitgeführten Wärme beaufschlagt wird.

9. Generator nach einem der Ansprüche 5 bis 8, dadurch gekennzeichnet, daß bei einer Ausbildung der Strahlungsquellen (3a bis 3e) als Brennstoffstrahler und einer Luftkühlung der Photozellen (7a bis 7d) die erwärmte Luft zur Unterstützung des Verbrennungsprozesses dient.

10. Generator nach einem der vorhergehenden Ansprüche, dadurch gekennzeichnet, daß er ein evakuiertes Gehäuse (2) aufweist, in dem die Strahlungsquellen (3a bis 3e) und die Photozellen (7a bis 7d) aufgenommen sind.

11. Generator nach einem der vorhergehenden Ansprüche, dadurch gekennzeichnet, daß er ein Gehäuse (2) aufweist, wobei ein oder mehrere Wände (2a bis 2d) an ihrer Innenseite eine reflektierende Isolation (9) aufweisen.
